# EUROPEAN PATENT APPLICATION

(11) **EP 4 583 161 A1**
(43) Date of publication of application: **09.07.2025**
(21) Application number: 24215528.1
(22) Date of filing: 26.11.2024
(51) Int. Cl.: H01L 23/498, H01L 23/538

(54) **VERTICALLY EMBEDDED COMPONENTS IN PACKAGE SUBSTRATES**

(30) Priority: 27.12.2023 US 202318397075
(71) Applicant: INTEL Corporation, Santa Clara, CA 95054 (US)
(72) Inventor: SHAN, Bohan, Chandler, 85226 (US); LIN, Ziyin, Chandler, 85226 (US); CARRAZZONE, Ryan, Chandler, 85226 (US); FENG, Hongxia, Chandler, 85249 (US); TANAKA, Hiroki, GILBERT, 85295 (US); CHEN, Haobo, Chandler, 85249 (US); BAI, Yiqun, Chandler, 85249 (US); ARRINGTON, Kyle J., GILBERT, 85297 (US); WAIMIN, Jose, Chandler, 85226 (US); RAMANUJA PIETAMBARAM, Srinivas Venkata, Chandler, 85249 (US); DUAN, Gang, Chandler, 85248 (US); XU, Dingying, Chandler, 85248 (US); Marin, Brandon C., Gilbert, 85234 (US); ARRINGTON, Clay, Queen Creek, 85142 (US); MIN, Yongki, Phoenix, 85045 (US); VAN NAUSDLE, Joseph, Chandler, 85286 (US); WALCZYK, Joe, Tigard, 97224 (US); TADAYON, Pooya, Portland, 97225 (US); SABER, Mohamed, College Station, 77845 (US)
(74) Representative: 2SPL Patentanwälte PartG mbB

(57) **Abstract**

In embodiments herein, circuit components are embedded within a core layer of a substrate. The circuit components are vertically oriented within a cavity or hole of the core layer of the substrate, e.g., with conductive contacts on an edge of the component that is substantially orthogonal to a plane of the core layer. The edge that is substantially orthogonal to a plane of the core layer may be the longest edge of the component.

## Description

### BACKGROUND

Circuit components, e.g., power delivery components such as inductors and capacitors, may be embedded within a core of a package substrate for an integrated circuit package. However, embedding components has proven to be difficult due to various factors, such as thickness mismatches between the core and the component, which can lead to tilting or shifting of the component within the cavity.

### BRIEF DESCRIPTION OF THE DRAWINGS

FIG. 1 illustrates an example package substrate with a horizontally embedded component in a core layer.
FIG. 2 illustrates an example multi-die integrated circuit package with a horizontally embedded component in a core layer.
FIGS. 3A-3B illustrate example issues that may be present with components embedded horizontally within a core of a package substrate.
FIGS. 4A-4G illustrate an example process of fabricating a package substrate with vertically embedded circuit components in accordance with embodiments of the present disclosure.
FIGS. 5A-5B illustrate examples of circuit components with redistribution layers, where the components are vertically embedded in a core layer of a substrate in accordance with embodiments of the present disclosure.
FIGS. 6A-6D illustrate examples of stacked circuit components with redistribution layers, where the components are vertically embedded in a core layer of a substrate in accordance with embodiments of the present disclosure.
FIGS. 7A-7B illustrate example systems that may incorporate the architectures described herein.
FIG. 8 is a top view of a wafer and dies that may be included in a microelectronic assembly, in accordance with any of the embodiments disclosed herein.
FIG. 9 is a cross-sectional side view of an integrated circuit device that may be included in a microelectronic assembly, in accordance with any of the embodiments disclosed herein.
FIG. 10 is a block diagram of an example electrical device that may include a microelectronic assembly, in accordance with any of the embodiments disclosed herein.

### DETAILED DESCRIPTION

Embodiments of the present disclosure relate to vertically embedding circuit components within the core layer of a package substrate, which can help mitigate issues related to thickness mismatches with the circuit component and the core layer as well as allow for higher densities of embedded components in the core layer. In particular, these issues can be well mitigated with vertically embedded components since the component's width (which becomes the height of the component in the core when vertically embedded therein) is more easily controlled/optimized during its manufacturing. Moreover, the vertical embedding can allow for stronger coplanarity of the component and the core layer surface(s). Further, since vertical embedding of the passive components can also enable placement of several components in one cavity, an attainable capacitance density for the package can be increased, and in certain instances, can also allow for electrical connections to be made through the core via the component itself.

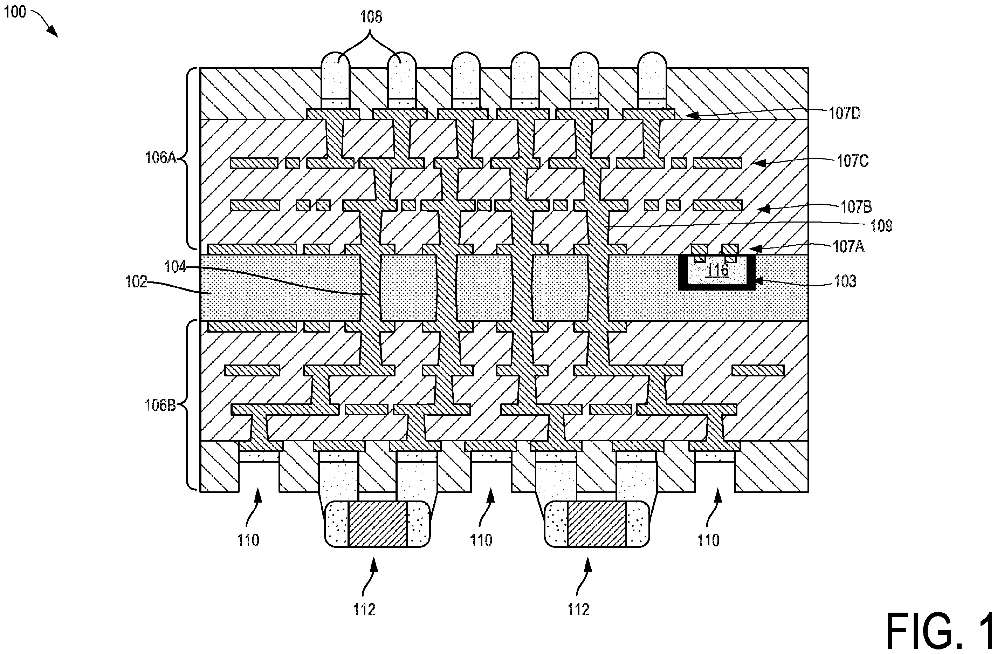

Typically, passive circuit components (e.g., capacitors) are large in their x- and y-directions and relatively thin in their z-direction. As shown in FIGS. 1-2, embedding of such components may typically be done in a horizontal orientation (i.e., with the longer dimension in the x- and y- directions as shown in those FIGS.). However, embodiments herein may orient the component generally orthogonal to this, such that the longer x- and y-dimensions of the component are aligned with the thickness of the core layer of the substrate, which can enable better thickness matching between the component and the core layer through control of the component's x- and y- dimensions. In particular embodiments, for instance, the longest dimension of the circuit component can be oriented vertically (e.g., orthogonal or substantially orthogonal to the plane of the core layer).

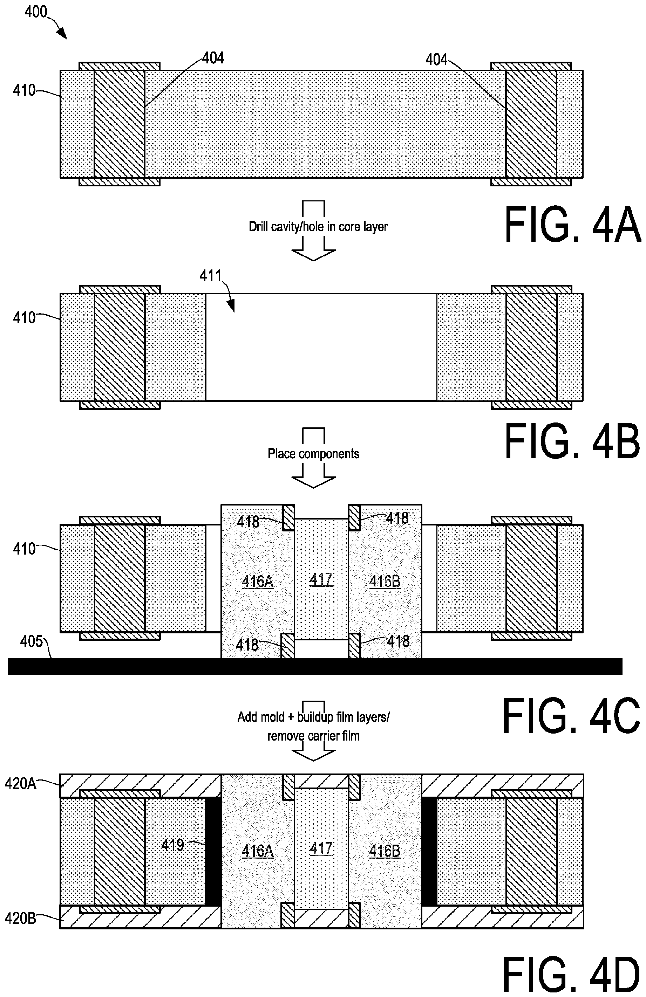

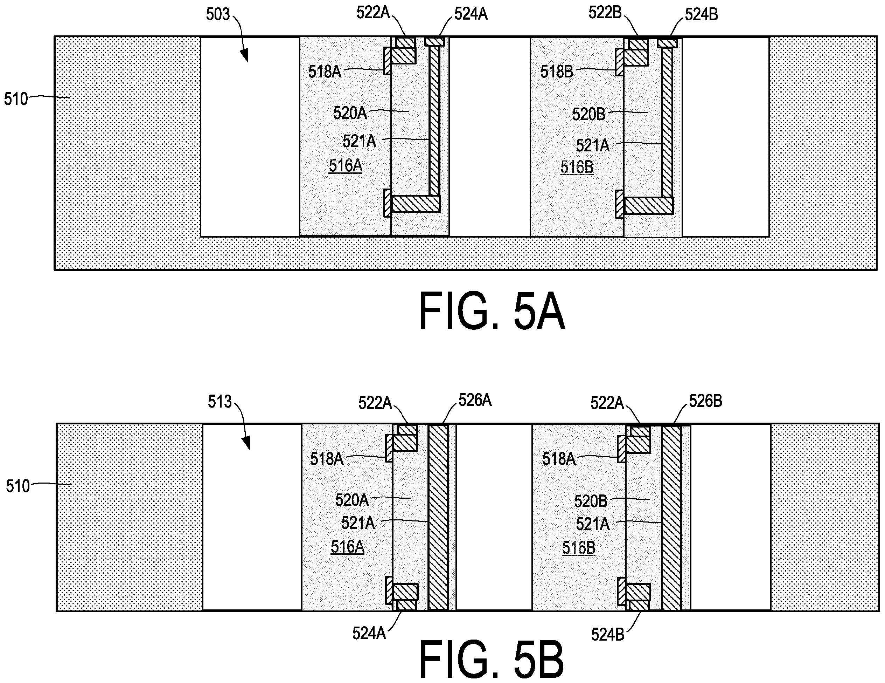

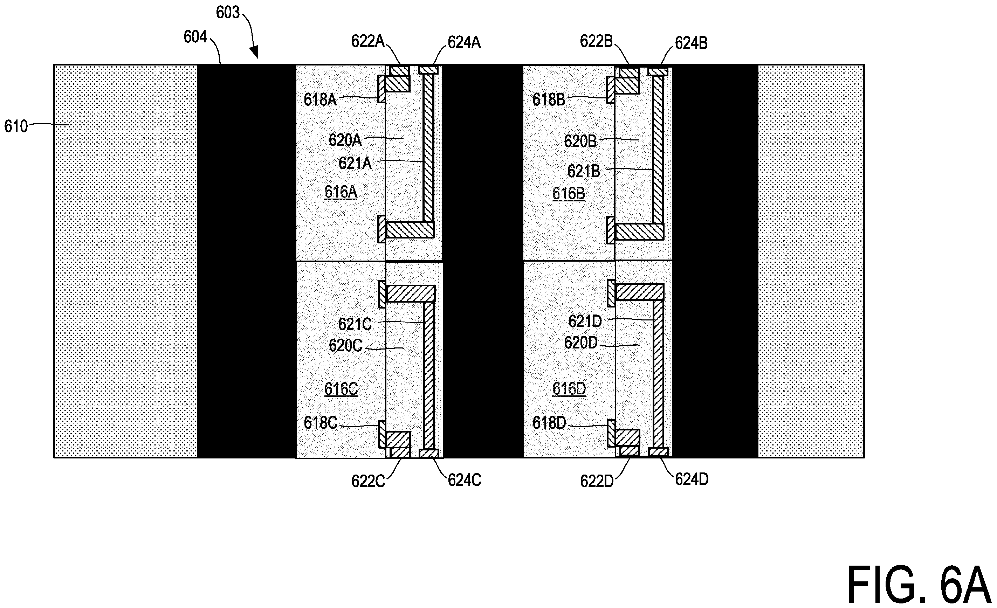

In some embodiments, the component to be embedded in the vertical manner can have electrical connections (e.g., metal pads) on the same edge(s) as it might normally, e.g., on the side of the component that would normally be facing up/down in the horizontal embedding scenario, and electrical connections (e.g., pads and vias) can be fabricated in buildup layers of the substrate to connect to the component's conductive contacts, e.g., as shown in FIGS. 4A-4G. In some embodiments, some redistribution layers can be fabricated on the longer surface(s) of the component to allow for routing of the original contacts of the component to the top or bottom, e.g. as shown in FIGS. 5A-5B. Vertical embedding can allow for multiple components to be embedded inside the core layer, including sets of stacked, vertically oriented components, e.g., as shown in FIGS. 6A-6D.

FIG. 1 illustrates an example package substrate 100 with a horizontally embedded component in a core layer. In particular, the example package substrate 100 includes a core layer 102 with buildup layers 106 formed on either side of the core layer 102, i.e., with buildup layers 106A on the top side of the core layer 102 and buildup layers 106B on the bottom side of the core layer 102. The buildup layers 106 include metal traces in metallization layers (e.g., 107A-D) and pillars (e.g., 109) between the metallization layers to electrically couple the solder bumps 108 at the top of the package substrate 100 with the pads 110 at the bottom of the substrate. In certain instances, for example, an integrated circuit die may be coupled to a top side of the package substrate 100 and connect to the solder bumps 108, and the package substrate 100 may be coupled to a circuit board (e.g., a motherboard, main board, etc.) via the pads 110 at the bottom of the package substrate 100. The package substrate 100 also includes land side capacitors 112 coupled on a bottom side of the package substrate 100.

In addition, the package substrate 100 includes a circuit component 116 that is embedded within the core layer 102, i.e., within a cavity 103 in the core layer 102. The circuit component 116 may be a passive circuit component, such as a capacitor or inductor, in certain embodiments, and may be placed within a cavity (e.g., as shown) or hole in the core layer 102. In some embodiments, the component 116 may be encapsulated with a mold material inside the cavity/hole in the core layer 102. Although shown in FIG. 1 as being horizontally oriented, the component 116 (or multiple components) may be vertically oriented in the core layer 102 in embodiments herein, e.g., as described further below.

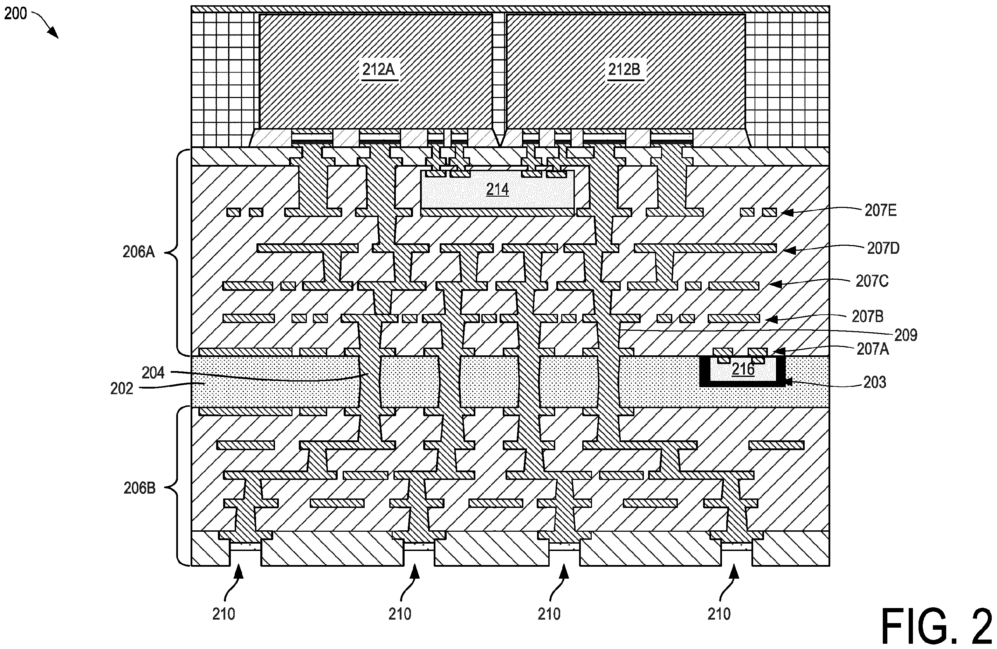

FIG. 2 illustrates an example multi-die integrated circuit package 200 with a horizontally embedded component 216 in a core layer of the package substrate. The package 200 includes a core layer 202 and vias 204 through the core layer 202. Buildup layers 206 are formed on the top and bottom sides of the core layer 202, with buildup layers 206A on the top side of the core layer 202 and the buildup layers 206B on bottom side of the core layer 202. The buildup layers 206 include metal traces in metallization layers (e.g., 207A-E) and pillars (e.g., 209) between the metallization layers as shown to electrically couple components on the top of the package 200 with the pads 210 at the bottom of the package. For example, the layers 206 may provide connections between the integrated circuit (IC) dies 212 coupled to the top side of the package to a circuit board (e.g., a motherboard, main board, etc.) via the pads 210 at the bottom of the package. The package 200 also includes a bridge circuitry component 214 located in the buildup layers 206A that electrically couples the first IC die 212A with the second IC die 212B. The bridge circuitry component 214 may include passive and/or active components to interconnect the IC dies 212. The bridge circuitry component 214 may be an Intel^{®} embedded multi-die interconnect bridge (EMIB) in certain embodiments.

In addition, the package 200 includes a circuit component 216 that is embedded within the core layer 202, i.e., within a cavity 203 in the core layer 202. Like the component 116 of FIG. 1, the circuit component 216 may be a passive circuit component, such as a capacitor or inductor, in certain embodiments, and may be placed within a cavity (e.g., as shown) or hole in the core layer 202. In some embodiments, the component 216 may be encapsulated with a mold material inside the cavity/hole in the core layer 202. Although shown in FIG. 2 as being horizontally oriented, the component 216 (or multiple components) may be vertically oriented in the core layer 202 in embodiments herein, e.g., as described further below.

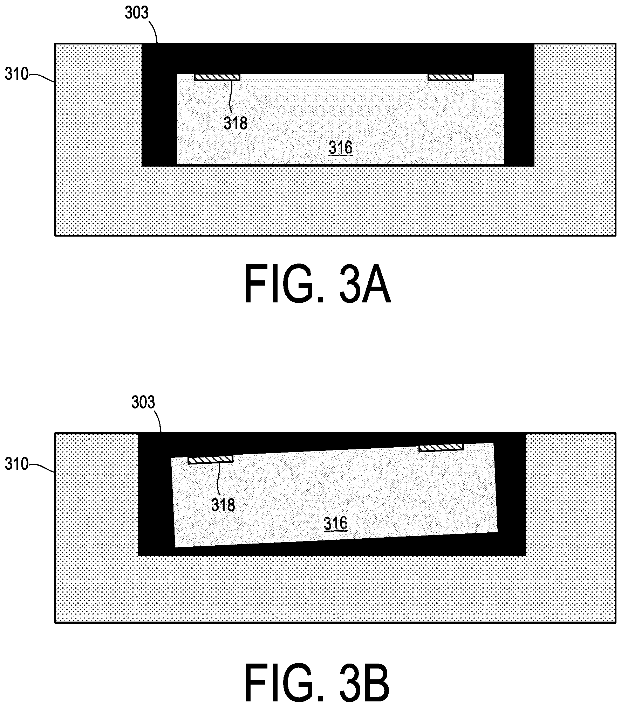

FIGS. 3A-3B illustrate example issues that may be present with components embedded horizontally within a core of a package substrate. In particular, FIG. 3A illustrates a mismatch in the height of the core layer 310 of the substrate and the component 316, while FIG 3B illustrates how the component 316 can "tilt" inside the cavity 303 of the core layer 310, i.e., not have its top surface (and thus, the pads 318) in alignment with the top surface of the core layer 310, which can cause issues with connectivity of the component 316 and the pads/traces of the buildup layers above the core layer 310. The thickness mismatch can be due to core layer 310 having a thickness of approximately 1-2mm (e.g., approximately 1.5mm), while the component has a thickness (z-dimension) of approximately 500-700um (e.g., approximately 650um thickness). The x- and y-dimensions may be on the order of 700-1 100um each, in certain instances, coming closer to the thickness of the core layer 310. Thus, vertical alignment of the component can prevent the thickness mismatch issue while also preventing the tilt issue and allowing for increased density of embedded components within the core layer.

FIGS. 4A-4G illustrate an example process 400 of fabricating a package substrate with vertically embedded circuit components in accordance with embodiments of the present disclosure. The process may include additional, fewer, or different operations than those shown or described below. For example, certain operations may be performed in a slightly different order than shown or may be performed simultaneously (when shown as separate steps). In some embodiments, one or more of the operations shown include multiple operations, sub-operations, etc. It will be understood that the example components shown might not be to scale, and that the core layer may be larger (e.g., in the x- and y-directions, with more vias, pads, or other components) than shown.

As shown in FIGS. 4A-4G, the circuit components 416 are vertically oriented in the core layer 410, i.e., the conductive contacts 418 of the components 416 are on a surface or edge of the respective components (the longer edges oriented vertically in the FIGS.) that is substantially orthogonal to the plane of the core layer 410 (horizontal in the FIGS.). As used herein, substantially orthogonal may refer to an arrangement where one item (e.g., an edge of the components 416) is oriented within 10 degrees of orthogonal (e.g., at an angle between 85-95 degrees) with respect to another item (e.g., the core layer 410). Although oriented on an edge that is orthogonal to the core layer and buildup layers, the top conductive contacts 418 may be in electrical connection with the conductive contacts of the buildup layers (e.g., 432) via certain intermediate conductive contacts (e.g., 424 in the example shown). The intermediate contacts may be co-planar with the core layer 410, in a first metallization layer of the buildup layers e.g., 424), or in another position. For instance, in some embodiments, e.g., those described further below, the contacts 418 may be in electrical connection with the buildup layers via redistribution layers in the edge of the components that is orthogonal to the plane of the core layer (i.e., redistribution layers that are above (in the horizontal orientation) or adjacent (in the vertical orientation) the conductive contacts 418).

The process 400 begins with a core layer 410 of a substrate. The core layer 410 may include plated through hole (PTH) vias 404 as shown in FIG. 4A. The core layer 410 may be an organic material (e.g., a material comprising Carbon, such as comprising Silicon and Carbon), or may be glass or glass-based material comprising Silicon (e.g., at least 26% by weight) and Oxygen (e.g., at least 26% by weight), potentially with one or more additive elements (e.g., as least 5% by weight) such as Aluminum, Boron, Magnesium, Calcium, Barium, Tin, Sodium, Potassium, Strontium, Phosphorus, Zirconium, Lithium, Titanium, and Zinc. Examples of glass core materials may include aluminosilicate, borosilicate, alumino-borosilicate, silica, or fused silica, and the materials may further include one or more additives, such as Al2O3, B2O3, MgO, CaO, SrO, BaO, SnO2, Na2O, K2O, SrO, P2O3, ZrO2, Li2O, Ti, and Zn.

A hole 411 (or cavity in other embodiments) is then drilled or otherwise formed in the core layer 410 as shown in FIG. 4B, and then components 416 are placed inside the hole as shown in FIG. 4C. The components 416 may be placed inside the hole so that they oriented in a vertical manner as shown. A carrier film 405 may be used to place the components and hold them in place until buildup film and/or mold materials are placed. In the example shown, there are two components 416A, 416B that are coupled together via a dielectric material 417. In various implementations, the dielectric material 417 may be an adhesive material, such as a die attach film. Each component 416 in the example shown includes two conductive contacts 418 on one of its longer sides as shown. However, the components 416 may include additional (e.g., up to eight or more) conductive contacts not shown in this example. When oriented in the vertical position as shown, one contact 418 (or set of contacts) is exposed on the top side of the core layer 410 and the other contact 418 (or set of contacts) on the bottom side of the core layer 410.

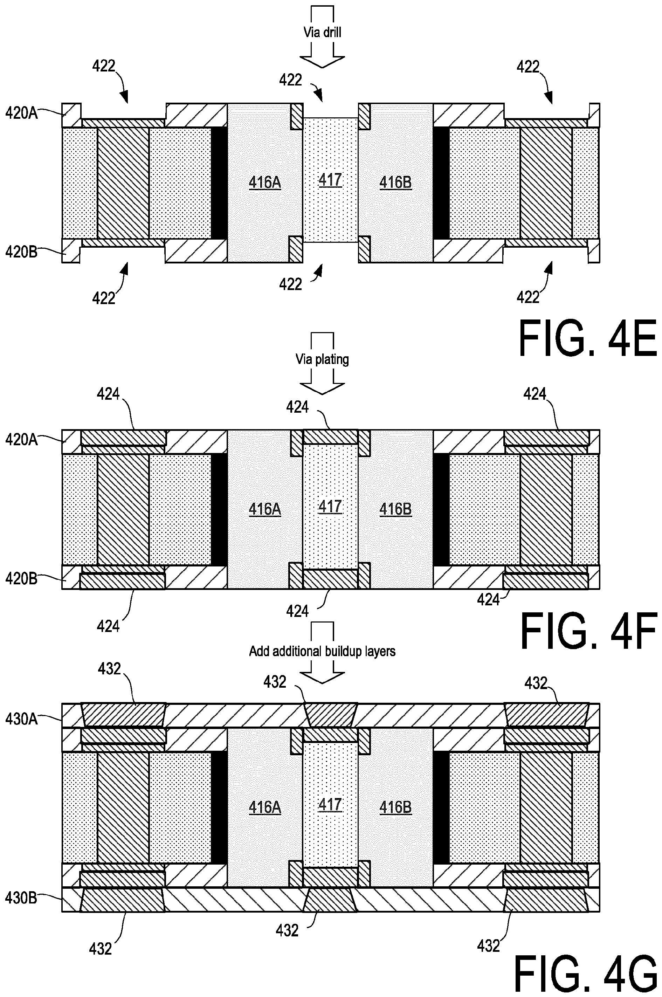

A mold material 419 may then be placed in the remaining open portions of the hole 411 and buildup layers 420 may be formed on either side of the core layer 410 as shown in FIG. 4D. The carrier film 405 holding the components 416 in place may also be removed, e.g., once the mold material 419 is placed. Then, holes 422 can be drilled in the buildup layers 420 and via pads 424 can be plated on the contacts as shown in FIGS. 4E and 4F, respectively. Additional buildup layers 430 with vias 432 (as well as other additional buildup layers/vias) can then be fabricated on either side of the substrate, as shown in FIG. 4G.

In the example shown, the top contacts 418 of the components 416 are in connection with upper buildup layers (e.g., 106A, 206A) of the resulting package substrate (through 424, 432), while the bottom contacts 418 of the components 416 are in connection with lower buildup layers of the resulting package substrate (e.g., 106B, 206B).

FIGS. 5A-5B illustrate examples of circuit components 516 with redistribution layers 520, where the components are vertically embedded in a core layer 510 of a substrate in accordance with embodiments of the present disclosure. In the examples shown, each component 516 is placed in a cavity 503 or hole 513 within the core layer 510, and is vertically oriented (i.e., with its longer side being oriented in the direction of the core layer's thickness. Although not explicitly shown, the cavity 503 and hole 513 may be filled with a mold or other dielectric material before buildup layers are formed on either side of the core layer 510, e.g., as described above.

Each component 516 includes conductive contacts 518 (e.g., pads) on its longer side (the right side of the component in FIGS. 5A-5B), and also includes redistribution layers 520 on the longer side that include traces 521 to connect the contacts 518 with other conductive contacts (e.g., 522, 524) at the top or bottom of the redistribution layers 520 as shown, allowing for vias, traces, etc. within buildup layers of the substrate above or below the core layer 510 to be in electrical contact with the contacts 518 on the side of the component 516. In addition, in the example shown in FIG. 5B, the redistribution layers 520 include vias 526 that allow for electrical connections through the core layer 51, which might not usually be an option with traditional horizontal component embedding techniques.

FIGS. 6A-6D illustrate examples of stacked circuit components 616 with redistribution layers 620, where the components 616 vertically embedded in a core layer 610 of a substrate in accordance with embodiments of the present disclosure. The components 616 are implemented in a similar manner as those in FIGS. 5A-5B. That is, each component 616 is placed in a hole 603 within the core layer 610, and is vertically oriented (i.e., with its longer side being oriented in the direction of the core layer's thickness. The components 616 are encapsulated by a mold material or other type of dielectric material 604 within the hole 603, e.g., before buildup layers are formed on either side of the core layer as described above.

Each component 616 includes conductive contacts 618 (e.g., pads) on its longer side (the right side of the component in FIGS. 6A-6D), and also includes redistribution layers 620 on the longer side that include traces 621 to connect the contacts 618 with other conductive contacts 622, 624 at the top or bottom of the redistribution layers 620 as shown, allowing for vias, traces, etc. within buildup layers of the substrate above or below the core layer 610 to be in electrical contact with the contacts 618 on the side of the component 616. In particular, the components 616A, 616B include redistribution layers 520A, 520B, respectively, with traces 521A, 521B that allow for connections to buildup layers above the core layer 610, and the components 616C, 616D include redistribution layers 520C, 520D, respectively, with traces 521C, 521D that allow for connections to buildup layers below the core layer 610. Although not shown, in some embodiments, the redistribution layers 520 may also include vias similar to the vias 526 shown in FIG. 5B to allow for connections between the buildup layers above and below the core layer 610.

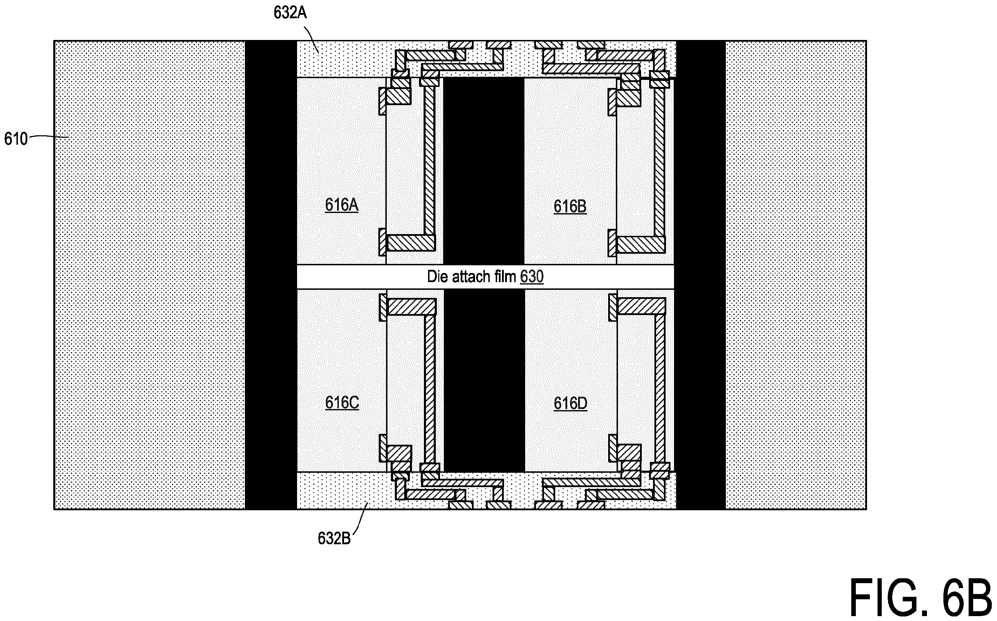

The example shown in FIG. 6A includes components 616 that are directly stacked on one another, while the example shown in FIG. 6B includes an adhesive die attach film 630 that couples the components 616A, 616B on the top to the components 616C, 616D on the bottom. In addition, the example shown in FIG. 6B further includes extra redistribution layers 632A, 632B above and below the component stack, respectively, to redistribute the connections from the components.

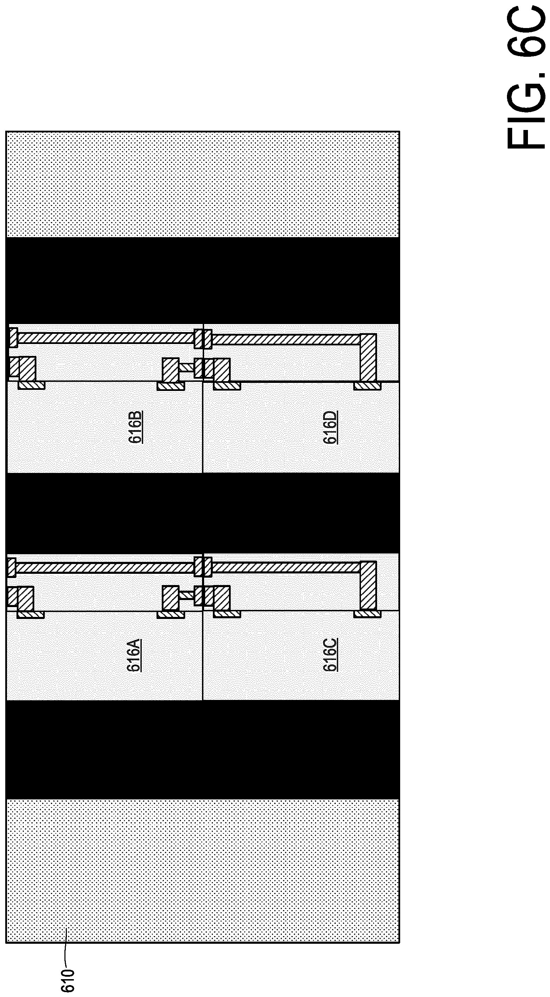

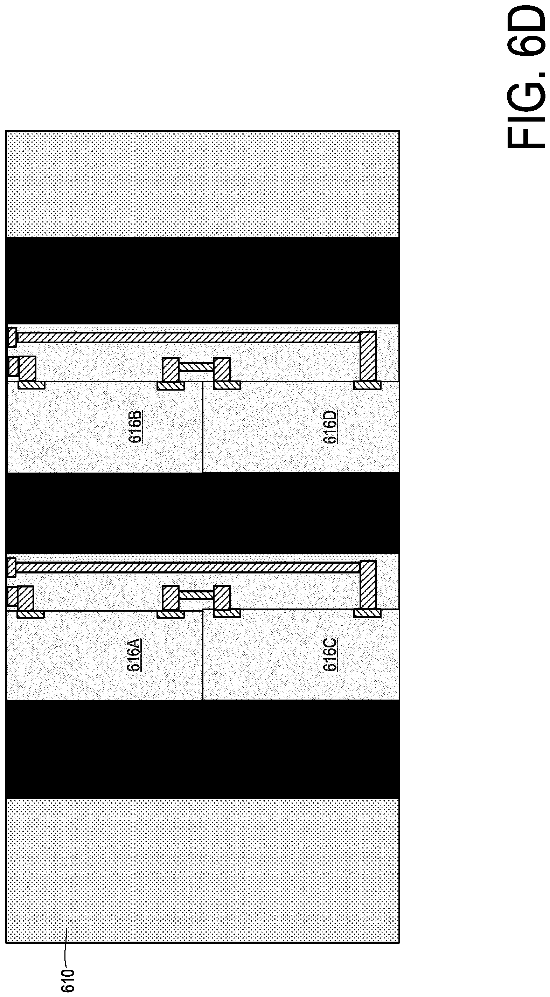

In the example shown in FIG. 6C, components having redistribution layers are directly stacked on one another similar to FIG. 6A. The top components 616A, 616B include vias in their redistribution layers that allow the bottom components 616C, 616D to connect to the top buildup layers as shown. The example shown in FIG. 6D is similar to that shown in FIG. 6B, with top components 616A, 616B stacked on the bottom components 616C, 616D, respectively. However, in contrast to the example of FIG. 6C, where the components have their own respective redistribution layers, the components in the example of FIG. 6D are stacked on one another, and then redistribution layers are formed across both components as shown. Thus, in the example shown in FIG. 6C, the components may be stacked on one another during the embedding process, while in the example shown in FIG. 6D, the components may be stacked on one another and have the redistribution layers formed before being embedded in the core layer.

Although FIGS. 6A-6D illustrate stacks of two components, embodiments herein may stack any suitable number of components on one another in a vertical orientation as shown and described above. The components may include their own respective redistribution layers similar to FIG. 6C, or may include shared redistribution layers for the stack, e.g., as shown in FIG. 6D.

In some embodiments, the embedded components (e.g., 416, 516, 616) may be deep trench capacitors, which are becoming increasingly important across the semiconductor industry. Stacking and rotating the orientation of such components can address issues of partial/incomplete filling for substrate core thicknesses greater than 700um, while also enabling a density scaling of the capacitors that benefits from the core thickness as designs are moved to larger filling ratios or for active silicon to inactive or bulk silicon. In some embodiments, the embedded components (e.g., 416, 516, 616) may be magnetic inductor arrays (MIAs).

In the horizontal orientation, the component may have a footprint that is several mm². However, by vertically embedding the components as described herein, the footprint of the component would be related to the active thickness of the device, which is on the order of 20-100um, and then either axis for the previous lateral footprint. This means that vertical embedding can scale as the thickness of the core also grows, e.g., from 700um to 1040um or 1480um or beyond, as additional capacitance volume can be embedded within the core without any impact in the cross-sectional area required. Stacking as shown in FIGS. 6A-6B can also help to allow for further densification, allowing for a more effective area utilization within the core of the substrate.

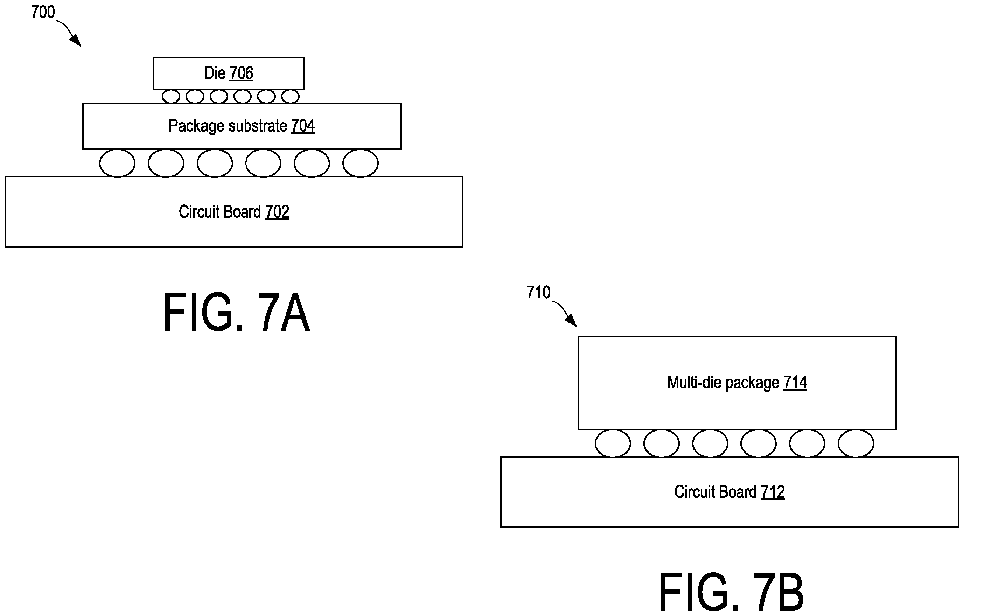

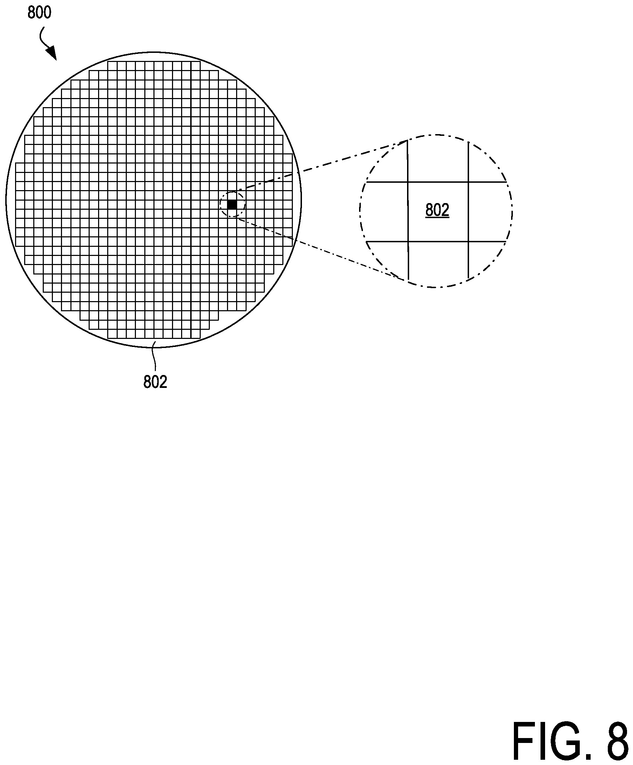

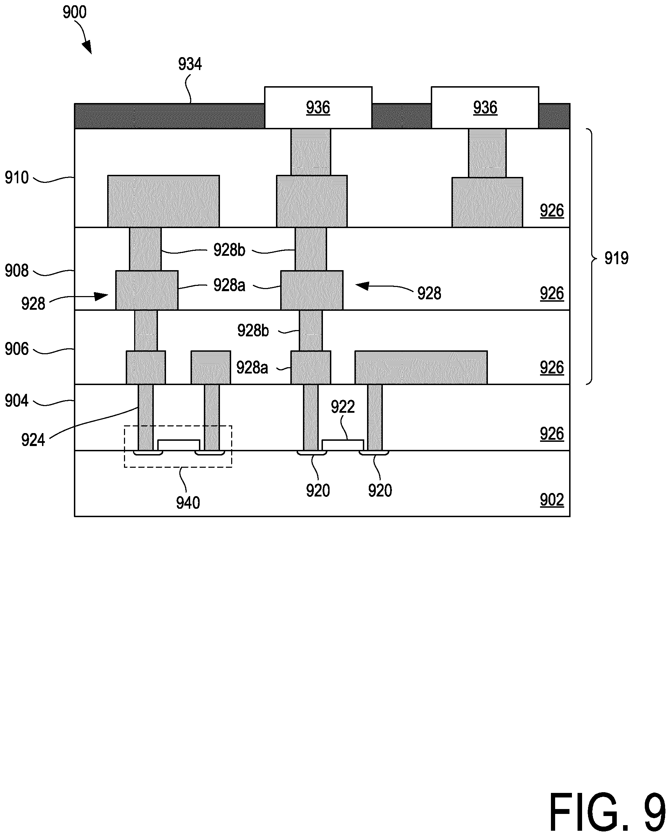

FIGS. 7A-7B illustrate example systems 700, 710 that may incorporate the architectures described herein. The example system 700 of FIG. 7A includes a circuit board 702, which may be implemented as a motherboard or main board of a computer system in some embodiments. The example system 700 also includes a package substrate 704 with an integrated circuit die 706 attached to the package substrate 704. The die 706 may be a packaged or unpacked integrated circuit product that includes one or more integrated circuit dies (e.g., the die 802 of FIG. 8, the integrated circuit device 900 of FIG. 9) and/or one or more other suitable components. The die 706 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the die 706 can comprise one or more additional active or passive devices such as capacitors, decoupling capacitors, resistors, inductors, fuses, diodes, transformers, sensors, electrostatic discharge (ESD) devices, and memory devices. In addition to comprising one or more processor units, the die 706 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". The package substrate 704 may provide electrical connections between the die 706 and the circuit board 702.

Similar to the system 700, the system 710 also includes a circuit board 712, which may be implemented as a motherboard or main board of a computer system in some embodiments. The system 710 also includes a multi-die package 714, which includes multiple integrated circuits/dies (e.g., 706), and interconnections between the dies in one or more metallization layers. The multi-die package 714 may include, for example, one or more silicon interposers, one or more silicon bridges embedded in the package substrate (e.g., an Intel^{®} embedded multi-die interconnect bridge (EMIB)), or combinations thereof.

The main circuit boards 702, 712 may provide electrical connections to other components of a computer system, e.g., memory, storage, network interfaces, peripheral devices, power supplies, etc. The main circuit board may include one or more traces and circuit components to provide interconnects between such computer system components.

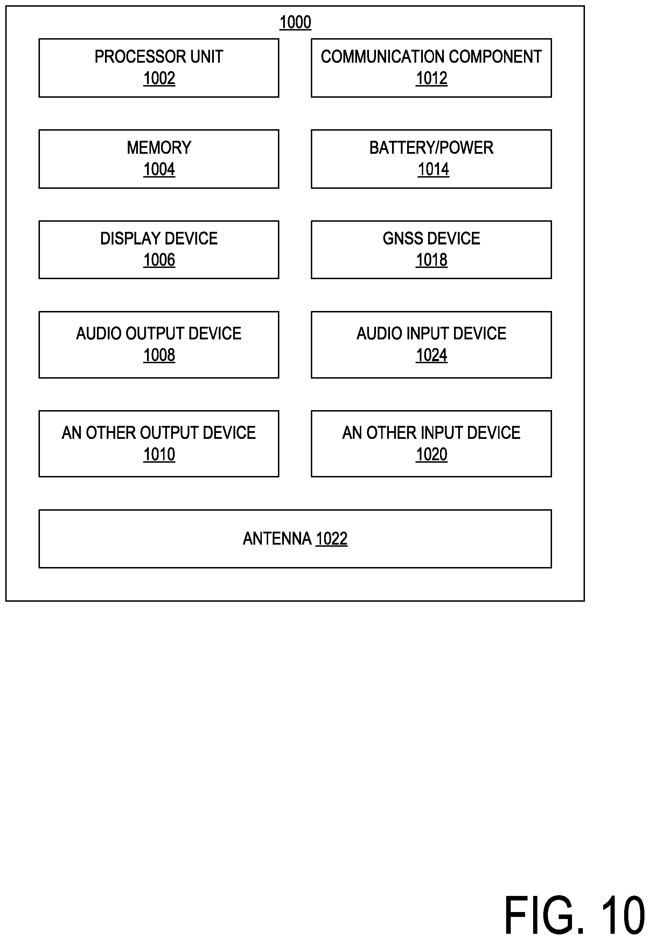

FIG. 8 is a top view of a wafer 800 and dies 802 that may incorporate any of the embodiments disclosed herein. The wafer 800 may be composed of semiconductor material and may include one or more dies 802 having integrated circuit structures formed on a surface of the wafer 800. The individual dies 802 may be a repeating unit of an integrated circuit product that includes any suitable integrated circuit. After the fabrication of the semiconductor product is complete, the wafer 800 may undergo a singulation process in which the dies 802 are separated from one another to provide discrete "chips" of the integrated circuit product. The die 802 may include one or more transistors (e.g., some of the transistors 940 of FIG. 9, discussed below), supporting circuitry to route electrical signals to the transistors, passive components (e.g., signal traces, resistors, capacitors, or inductors), and/or any other integrated circuit components. In some embodiments, the wafer 800 or the die 802 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 802. For example, a memory array formed by multiple memory devices may be formed on a same die 802 as a processor unit (e.g., the processor unit 1002 of FIG. 10) or other logic that is configured to store information in the memory devices or execute instructions stored in the memory array.

FIG. 9 is a cross-sectional side view of an integrated circuit device 900 that may be included in any of the embodiments disclosed herein. One or more of the integrated circuit devices 900 may be included in one or more dies 802 (FIG. 8). The integrated circuit device 900 may be formed on a die substrate 902 (e.g., the wafer 800 of FIG. 8) and may be included in a die (e.g., the die 802 of FIG. 8). The die substrate 902 may be a semiconductor substrate composed of semiconductor material systems including, for example, n-type or p-type materials systems (or a combination of both). The die substrate 902 may include, for example, a crystalline substrate formed using a bulk silicon or a silicon-on-insulator (SOI) substructure. In some embodiments, the die substrate 902 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 902. Although a few examples of materials from which the die substrate 902 may be formed are described here, any material that may serve as a foundation for an integrated circuit device 900 may be used. The die substrate 902 may be part of a singulated die (e.g., the dies 802 of FIG. 8) or a wafer (e.g., the wafer 800 of FIG. 8).

The integrated circuit device 900 may include one or more device layers 904 disposed on the die substrate 902. The device layer 904 may include features of one or more transistors 940 (e.g., metal oxide semiconductor field-effect transistors (MOSFETs) or ferroelectric field-effect transistors (FeFETs), e.g., those described herein) formed on the die substrate 902. The transistors 940 may include, for example, one or more source and/or drain (S/D) regions 920, a gate 922 to control current flow between the S/D regions 920, and one or more S/D contacts 924 to route electrical signals to/from the S/D regions 920. The transistors 940 may include additional features not depicted for the sake of clarity, such as device isolation regions, gate contacts, and the like. The transistors 940 are not limited to the type and configuration depicted in FIG. 9 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

Returning to FIG. 9, the example transistor 940 may include a gate 922 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 940 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 940 along the source-channel-drain direction, the gate electrode may consist of a U-shaped structure that includes a bottom portion substantially parallel to the surface of the die substrate 902 and two sidewall portions that are substantially perpendicular to the top surface of the die substrate 902. In other embodiments, at least one of the metal layers that form the gate electrode may simply be a planar layer that is substantially parallel to the top surface of the die substrate 902 and does not include sidewall portions substantially perpendicular to the top surface of the die substrate 902. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 920 may be formed within the die substrate 902 adjacent to the gate 922 of individual transistors 940. The S/D regions 920 may be formed using an implantation/diffusion process or an etching/deposition process, for example. In the former process, dopants such as boron, aluminum, antimony, phosphorous, or arsenic may be ion-implanted into the die substrate 902 to form the S/D regions 920. An annealing process that activates the dopants and causes them to diffuse farther into the die substrate 902 may follow the ion-implantation process. In the latter process, the die substrate 902 may first be etched to form recesses at the locations of the S/D regions 920. An epitaxial deposition process may then be carried out to fill the recesses with material that is used to fabricate the S/D regions 920. In some implementations, the S/D regions 920 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 920 may be formed using one or more alternate semiconductor materials such as germanium or a group III-V material or alloy. In further embodiments, one or more layers of metal and/or metal alloys may be used to form the S/D regions 920.

Electrical signals, such as power and/or input/output (I/O) signals, may be routed to and/or from the devices (e.g., transistors 940) of the device layer 904 through one or more interconnect layers disposed on the device layer 904 (illustrated in FIG. 9 as interconnect layers 906-910). For example, electrically conductive features of the device layer 904 (e.g., the gate 922 and the S/D contacts 924) may be electrically coupled with the interconnect structures 928 of the interconnect layers 906-910. The one or more interconnect layers 906-910 may form a metallization stack (also referred to as an "ILD stack") 919 of the integrated circuit device 900.

The interconnect structures 928 may be arranged within the interconnect layers 906-910 to route electrical signals according to a wide variety of designs; in particular, the arrangement is not limited to the particular configuration of interconnect structures 928 depicted in FIG. 9. Although a particular number of interconnect layers 906-910 is depicted in FIG. 9, embodiments of the present disclosure include integrated circuit devices having more or fewer interconnect layers than depicted.

In some embodiments, the interconnect structures 928 may include lines 928a and/or vias 928b filled with an electrically conductive material such as a metal. The lines 928a may be arranged to route electrical signals in a direction of a plane that is substantially parallel with a surface of the die substrate 902 upon which the device layer 904 is formed. For example, the lines 928a may route electrical signals in a direction in and out of the page and/or in a direction across the page from the perspective of FIG. 9. The vias 928b may be arranged to route electrical signals in a direction of a plane that is substantially perpendicular to the surface of the die substrate 902 upon which the device layer 904 is formed. In some embodiments, the vias 928b may electrically couple lines 928a of different interconnect layers 906-910 together.

The interconnect layers 906-910 may include a dielectric material 926 disposed between the interconnect structures 928, as shown in FIG. 9. In some embodiments, dielectric material 926 disposed between the interconnect structures 928 in different ones of the interconnect layers 906-910 may have different compositions; in other embodiments, the composition of the dielectric material 926 between different interconnect layers 906-910 may be the same. The device layer 904 may include a dielectric material 926 disposed between the transistors 940 and a bottom layer of the metallization stack as well. The dielectric material 926 included in the device layer 904 may have a different composition than the dielectric material 926 included in the interconnect layers 906-910; in other embodiments, the composition of the dielectric material 926 in the device layer 904 may be the same as a dielectric material 926 included in any one of the interconnect layers 906-910.

A first interconnect layer 906 (referred to as Metal 1 or "M1") may be formed directly on the device layer 904. In some embodiments, the first interconnect layer 906 may include lines 928a and/or vias 928b, as shown. The lines 928a of the first interconnect layer 906 may be coupled with contacts (e.g., the S/D contacts 924) of the device layer 904. The vias 928b of the first interconnect layer 906 may be coupled with the lines 928a of a second interconnect layer 908.

The second interconnect layer 908 (referred to as Metal 2 or "M2") may be formed directly on the first interconnect layer 906. In some embodiments, the second interconnect layer 908 may include via 928b to couple the lines 928 of the second interconnect layer 908 with the lines 928a of a third interconnect layer 910. Although the lines 928a and the vias 928b are structurally delineated with a line within individual interconnect layers for the sake of clarity, the lines 928a and the vias 928b may be structurally and/or materially contiguous (e.g., simultaneously filled during a dual-damascene process) in some embodiments.

The third interconnect layer 910 (referred to as Metal 3 or "M3") (and additional interconnect layers, as desired) may be formed in succession on the second interconnect layer 908 according to similar techniques and configurations described in connection with the second interconnect layer 908 or the first interconnect layer 906. In some embodiments, the interconnect layers that are "higher up" in the metallization stack 919 in the integrated circuit device 900 (i.e., farther away from the device layer 904) may be thicker that the interconnect layers that are lower in the metallization stack 919, with lines 928a and vias 928b in the higher interconnect layers being thicker than those in the lower interconnect layers.

The integrated circuit device 900 may include a solder resist material 934 (e.g., polyimide or similar material) and one or more conductive contacts 936 formed on the interconnect layers 906-910. In FIG. 9, the conductive contacts 936 are illustrated as taking the form of bond pads. The conductive contacts 936 may be electrically coupled with the interconnect structures 928 and configured to route the electrical signals of the transistor(s) 940 to external devices. For example, solder bonds may be formed on the one or more conductive contacts 936 to mechanically and/or electrically couple an integrated circuit die including the integrated circuit device 900 with another component (e.g., a printed circuit board). The integrated circuit device 900 may include additional or alternate structures to route the electrical signals from the interconnect layers 906-910; for example, the conductive contacts 936 may include other analogous features (e.g., posts) that route the electrical signals to external components.

In some embodiments in which the integrated circuit device 900 is a double-sided die, the integrated circuit device 900 may include another metallization stack (not shown) on the opposite side of the device layer(s) 904. This metallization stack may include multiple interconnect layers as discussed above with reference to the interconnect layers 906-910, to provide conductive pathways (e.g., including conductive lines and vias) between the device layer(s) 904 and additional conductive contacts (not shown) on the opposite side of the integrated circuit device 900 from the conductive contacts 936.

In other embodiments in which the integrated circuit device 900 is a double-sided die, the integrated circuit device 900 may include one or more through silicon vias (TSVs) through the die substrate 902; these TSVs may make contact with the device layer(s) 904, and may provide conductive pathways between the device layer(s) 904 and additional conductive contacts (not shown) on the opposite side of the integrated circuit device 900 from the conductive contacts 936. In some embodiments, TSVs extending through the substrate can be used for routing power and ground signals from conductive contacts on the opposite side of the integrated circuit device 900 from the conductive contacts 936 to the transistors 940 and any other components integrated into the die 900, and the metallization stack 919 can be used to route I/O signals from the conductive contacts 936 to transistors 940 and any other components integrated into the die 900.

Multiple integrated circuit devices 900 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

FIG. 10 is a block diagram of an example electrical device 1000 that may include one or more of the embodiments disclosed herein. For example, any suitable ones of the components of the electrical device 1000 may include one or more of the integrated circuit devices 900 or integrated circuit dies 802 disclosed herein. A number of components are illustrated in FIG. 10 as included in the electrical device 1000, but any one or more of these components may be omitted or duplicated, as suitable for the application. In some embodiments, some or all of the components included in the electrical device 1000 may be attached to one or more motherboards mainboards, or system boards. In some embodiments, one or more of these components are fabricated onto a single system-on-a-chip (SoC) die.

Additionally, in various embodiments, the electrical device 1000 may not include one or more of the components illustrated in FIG. 10, but the electrical device 1000 may include interface circuitry for coupling to the one or more components. For example, the electrical device 1000 may not include a display device 1006, but may include display device interface circuitry (e.g., a connector and driver circuitry) to which a display device 1006 may be coupled. In another set of examples, the electrical device 1000 may not include an audio input device 1024 or an audio output device 1008, but may include audio input or output device interface circuitry (e.g., connectors and supporting circuitry) to which an audio input device 1024 or audio output device 1008 may be coupled.

The electrical device 1000 may include one or more processor units 1002 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1002 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1000 may include a memory 1004, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1004 may include memory that is located on the same integrated circuit die as the processor unit 1002. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1000 can comprise one or more processor units 1002 that are heterogeneous or asymmetric to another processor unit 1002 in the electrical device 1000. There can be a variety of differences between the processing units 1002 in a system in terms of a spectrum of metrics of merit including architectural, microarchitectural, thermal, power consumption characteristics, and the like. These differences can effectively manifest themselves as asymmetry and heterogeneity among the processor units 1002 in the electrical device 1000.

In some embodiments, the electrical device 1000 may include a communication component 1012 (e.g., one or more communication components). For example, the communication component 1012 can manage wireless communications for the transfer of data to and from the electrical device 1000. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1012 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1012 may operate in accordance with other wireless protocols in other embodiments. The electrical device 1000 may include an antenna 1022 to facilitate wireless communications and/or to receive other wireless communications (such as AM or FM radio transmissions).

In some embodiments, the communication component 1012 may manage wired communications, such as electrical, optical, or any other suitable communication protocols (e.g., IEEE 802.3 Ethernet standards). As noted above, the communication component 1012 may include multiple communication components. For instance, a first communication component 1012 may be dedicated to shorter-range wireless communications such as Wi-Fi or Bluetooth, and a second communication component 1012 may be dedicated to longer-range wireless communications such as global positioning system (GPS), EDGE, GPRS, CDMA, WiMAX, LTE, EV-DO, or others. In some embodiments, a first communication component 1012 may be dedicated to wireless communications, and a second communication component 1012 may be dedicated to wired communications.

The electrical device 1000 may include battery/power circuitry 1014. The battery/power circuitry 1014 may include one or more energy storage devices (e.g., batteries or capacitors) and/or circuitry for coupling components of the electrical device 1000 to an energy source separate from the electrical device 1000 (e.g., AC line power).

The electrical device 1000 may include a display device 1006 (or corresponding interface circuitry, as discussed above). The display device 1006 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1000 may include an audio output device 1008 (or corresponding interface circuitry, as discussed above). The audio output device 1008 may include any embedded or wired or wirelessly connected external device that generates an audible indicator, such speakers, headsets, or earbuds.

The electrical device 1000 may include an audio input device 1024 (or corresponding interface circuitry, as discussed above). The audio input device 1024 may include any embedded or wired or wirelessly connected device that generates a signal representative of a sound, such as microphones, microphone arrays, or digital instruments (e.g., instruments having a musical instrument digital interface (MIDI) output). The electrical device 1000 may include a Global Navigation Satellite System (GNSS) device 1018 (or corresponding interface circuitry, as discussed above), such as a Global Positioning System (GPS) device. The GNSS device 1018 may be in communication with a satellite-based system and may determine a geolocation of the electrical device 1000 based on information received from one or more GNSS satellites, as known in the art.

The electrical device 1000 may include an other output device 1010 (or corresponding interface circuitry, as discussed above). Examples of the other output device 1010 may include an audio codec, a video codec, a printer, a wired or wireless transmitter for providing information to other devices, or an additional storage device.

The electrical device 1000 may include another input device 1020 (or corresponding interface circuitry, as discussed above). Examples of the other input device 1020 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1000 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1000 may be any other electronic device that processes data. In some embodiments, the electrical device 1000 may comprise multiple discrete physical components. Given the range of devices that the electrical device 1000 can be manifested as in various embodiments, in some embodiments, the electrical device 1000 can be referred to as a computing device or a computing system.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 is an integrated circuit package substrate comprising: a core layer; a circuit component inside the core layer; and buildup layers on a first side of the core layer, the buildup layers comprising a plurality of metallization layers connected by metal pillars; wherein the circuit component comprises a conductive contact on an edge of the circuit component that is substantially orthogonal to a plane of the core layer, the conductive contact of the circuit component connected to a conductive contact in the buildup layers.

Example 1.1 is an integrated circuit package substrate comprising: a core layer; buildup layers on the core layer, the buildup layers comprising a plurality of metallization layers; and a circuit component within the core layer, the circuit component comprising conductive contacts on an edge of the circuit component that is substantially orthogonal to a plane of the core layer, the conductive contacts of the circuit component in connection with at least one metallization layer.

Example 1.2 is an integrated circuit package substrate comprising: a core layer; buildup layers on a first side of the core layer, the buildup layers comprising a plurality of metallization layers; and a circuit component oriented inside the core layer such that a longest edge of the circuit component is substantially orthogonal to a plane of the core layer, wherein the circuit component comprises conductive contacts on the longest edge connected to a metallization layer.

Example 2 includes the subject matter of any preceding Example, wherein the circuit component comprises one or more redistribution layers comprising conductive traces to connect the conductive contact of the circuit component with the conductive contact in the buildup layers.

Example 3 includes the subject matter of Example 2, wherein the redistribution layers are on the edge that is substantially orthogonal to the plane of the core layer.

Example 4 includes the subject matter of Example 2 or 3, wherein the edge that is substantially orthogonal to the plane of the core layer is a first edge, and the redistribution layers further comprise an electrical trace between a second edge of the circuit component and a third edge of the circuit component opposite the second edge, the second edge and the third edge substantially orthogonal to the first edge.

Example 4.1 includes the subject matter of Example 4, wherein a length of the first edge is greater than a length of the second edge and a length of the third edge.

Example 5 includes the subject matter of any preceding Example, wherein the buildup layers are first buildup layers, the conductive contact of the circuit component is a first conductive contact of the circuit component, and the substrate further comprises second buildup layers on a second side of the core layer opposite the first side, the second buildup layers comprising a plurality of metallization layers connected by metal pillars, wherein the circuit component further comprises a second conductive contact on the first edge that is connected to a conductive contact in the second buildup layers.

Example 6 includes the subject matter of any preceding Example, wherein the circuit component is a first circuit component and the substrate further comprises a second circuit component inside the core layer, the second circuit component comprising a conductive contact on an edge of the second circuit component that is substantially orthogonal to the plane of the core layer, the conductive contact of the second circuit component connected to a conductive contact in the buildup layers.

Example 7 includes the subject matter of Example 6, wherein the conductive contact of the second circuit component is connected to the same conductive contact in the buildup layers as the conductive contact of the first circuit component.

Example 8 includes the subject matter of Example 6, wherein the second circuit component comprises redistribution layers comprising conductive traces to connect the conductive contact of the second circuit component with the conductive contact in the buildup layers.

Example 9 includes the subject matter of any preceding Example, wherein the circuit component is a first circuit component and the substrate further comprises a second circuit component inside the core layer under the first circuit component.

Example 10 includes the subject matter of Example 9, wherein the second circuit component comprises a conductive contact on an edge of the second circuit component that is substantially orthogonal to the plane of the core layer, the conductive contact of the second circuit component connected to a conductive contact in the buildup layers.

Example 11 includes the subject matter of Example 9, further comprising second buildup layers on a second side of the core layer opposite the first side, the second buildup layers comprising a plurality of metallization layers connected by metal pillars, wherein the second circuit component comprises a conductive contact on an edge of the second circuit component that is substantially orthogonal to the plane of the core layer, the conductive contact of the second circuit component connected to a conductive contact in the second buildup layers.

Example 12 includes the subject matter of any preceding Example, wherein the core layer comprises an organic material.

Example 13 includes the subject matter of any preceding Example, wherein the core layer comprises glass.

Example 14 includes the subject matter of any preceding Example, wherein the circuit component is a capacitor or inductor.

Example 15 includes the subject matter of Example 14, wherein the circuit component is a deep trench capacitor.

Example 16 is an integrated circuit package comprising: an integrated circuit package substrate according to any preceding Example; and an integrated circuit die coupled to the package substrate.

Example 17 is a system comprising: a circuit board; and an integrated circuit package coupled to the circuit board, the integrated circuit package according to Example 16.

In the above description, various aspects of the illustrative implementations have been described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials, and configurations have been set forth to provide a thorough understanding of the illustrative implementations. However, it will be apparent to one skilled in the art that the present disclosure may be practiced without all of the specific details. In other instances, well-known features have been omitted or simplified in order not to obscure the illustrative implementations.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

The above description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

In various embodiments, the phrase "located on" in the context of a first layer or component located on a second layer or component refers to the first layer or component being directly physically attached to the second part or component (no layers or components between the first and second layers or components) or physically attached to the second layer or component with one or more intervening layers or components.

In various embodiments, the term "adjacent" refers to layers or components that are in physical contact with each other. That is, there is no layer or component between the stated adjacent layers or components. For example, a layer X that is adjacent to a layer Y refers to a layer that is in physical contact with layer Y.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

## Claims

1. An integrated circuit package substrate comprising:
a core layer;
a circuit component inside the core layer; and
buildup layers on a first side of the core layer, the buildup layers comprising a plurality of metallization layers;
wherein the circuit component comprises a conductive contact on an edge of the circuit component that is substantially orthogonal to a plane of the core layer, the conductive contact of the circuit component connected to a conductive contact in the buildup layers.

2. The integrated circuit package substrate of claim 1, wherein the circuit component comprises one or more redistribution layers comprising conductive traces to connect the conductive contact of the circuit component with the conductive contact in the buildup layers.

3. The integrated circuit package substrate of claim 2, wherein the redistribution layers are on the edge that is substantially orthogonal to the plane of the core layer.

4. The integrated circuit package substrate of claim 2 or 3, wherein the edge that is substantially orthogonal to the plane of the core layer is a first edge, and the redistribution layers further comprise an electrical trace between a second edge of the circuit component and a third edge of the circuit component opposite the second edge, the second edge and the third edge substantially orthogonal to the first edge.

5. The integrated circuit package substrate of claim 4, wherein a length of the first edge is greater than a length of the second edge and a length of the third edge.

6. The integrated circuit package substrate of any one of claims 1-5, wherein the buildup layers are first buildup layers, the conductive contact of the circuit component is a first conductive contact of the circuit component, and the substrate further comprises second buildup layers on a second side of the core layer opposite the first side, the second buildup layers comprising a plurality of metallization layers connected by metal pillars, wherein the circuit component further comprises a second conductive contact on the first edge that is connected to a conductive contact in the second buildup layers.

7. The integrated circuit package substrate of any one of claims 1-6, wherein the circuit component is a first circuit component and the substrate further comprises a second circuit component inside the core layer, the second circuit component comprising a conductive contact on an edge of the second circuit component that is substantially orthogonal to the plane of the core layer, the conductive contact of the second circuit component connected to a conductive contact in the buildup layers.

8. The integrated circuit package substrate of claim 7, wherein the conductive contact of the second circuit component is connected to the same conductive contact in the buildup layers as the conductive contact of the first circuit component.

9. The integrated circuit package substrate of claim 7 or 8, wherein the second circuit component comprises redistribution layers comprising conductive traces to connect the conductive contact of the second circuit component with the conductive contact in the buildup layers.

10. The integrated circuit package substrate of any one of claims 1-9, wherein the circuit component is a first circuit component and the substrate further comprises a second circuit component inside the core layer under the first circuit component.

11. The integrated circuit package substrate of claim 10, wherein the second circuit component comprises a conductive contact on an edge of the second circuit component that is substantially orthogonal to the plane of the core layer, the conductive contact of the second circuit component connected to a conductive contact in the buildup layers.

12. The integrated circuit package substrate of claim 10 or 11, further comprising second buildup layers on a second side of the core layer opposite the first side, the second buildup layers comprising a plurality of metallization layers connected by metal pillars, wherein the second circuit component comprises a conductive contact on an edge of the second circuit component that is substantially orthogonal to the plane of the core layer, the conductive contact of the second circuit component connected to a conductive contact in the second buildup layers.

13. The integrated circuit package substrate of any one of claims 1-12, wherein the circuit component is a capacitor or inductor.

14. An integrated circuit package comprising: an integrated circuit package substrate according to any preceding claim; and an integrated circuit die coupled to the package substrate.

15. A system comprising: a circuit board; and an integrated circuit package coupled to the circuit board, the integrated circuit package according to claim 14.
